# EUROPEAN PATENT APPLICATION

(11) **EP 4 386 429 A1**
(43) Date of publication of application: **19.06.2024**
(21) Application number: 22869896.5
(22) Date of filing: 08.09.2022
(51) Int. Cl.: G01S 7/36, G01M 17/007

(54) **DESIGN METHOD FOR TARGET OBJECT, AND DESIGN METHOD FOR VEHICLE DRIVING TEST DEVICE**

(30) Priority: 15.09.2021 JP 2021150662
(71) Applicant: Mitsubishi Heavy Industries, Ltd., Tokyo 100-8332 (JP)
(72) Inventor: TANEMURA, Tsunetoshi, Tokyo 100-8332 (JP); TAKAKUWA, Yoshinao, Kobe-shi, Hyogo 652-8585 (JP); HIDAKA, Fumiyasu, Kobe-shi, Hyogo 652-8585 (JP); HINENO, Yoshikatsu, Kobe-shi, Hyogo 652-8585 (JP)
(74) Representative: Hoffmann Eitle
(86) International application number: PCT/JP2022/033766
(87) International publication number: WO 2023/042749

(57) **Abstract**

This design method for a target object includes: an acquisition step for acquiring information pertaining to the state of reflection and scattering of electromagnetic waves on a target object in a case in which the electromagnetic waves are irradiated onto the target object; an identification step for identifying, on the basis of the information, a portion at which predetermined reflection and scattering occur on the target object; a change step for changing a surface state of the portion at which the predetermined reflection and scattering occur on the target object so that the predetermined reflection and scattering at the portion at which the predetermined reflection and scattering occur on the target object are suppressed; and a verification step for verifying the states of the predetermined reflection and scattering of the electromagnetic waves on the target object in a case in which the electromagnetic waves are irradiated onto the target object having the changed surface state.

## Description

### Technical Field

The present disclosure relates to a design method for a target object, and a design method for a vehicle driving test device.

### Background Art

In a case of irradiating electromagnetic waves onto a target object, the electromagnetic waves are reflected and scattered according to a shape, a material, etc. of the target object, and return to an electromagnetic wave arrival direction. Remote sensing such as a radar or the like uses this phenomenon to measure an existence position, a movement direction, etc. of the target object in a noncontact manner. As an example of such a target object, there is known a vehicle driving test device that reproduces conditions of various peripheral vehicles existing in an actual environment and performs a vehicle driving test (see, for example, PTL 1).

### Citation List

### Patent Literature

[PTL 1] Japanese Unexamined Patent Application Publication No. 2021-42997

### Summary of Invention

### Technical Problem

In some cases, a target object is designed for the purpose of making it difficult to be detected by the remote sensing, assuming that a design target object can be a detection target object by the remote sensing. Alternatively, as a similarity to this state, there is a case in which a surrounding environment in which the detection target object exists is optimized by the remote sensing. For example, depending on the surrounding environment, there may be a case in which undesired reflection and scattering occur during the detection of the detection target object, and this may cause difficulty in the detection of the detection target object. In order to solve this problem, it is required to optimize the surrounding environment. As such an example, for example, there is a structure such as a bridge, or a building in the vicinity of a fixed facility such as a radar or the like that emits the electromagnetic waves.

The present disclosure has been made in view of the above, and an object thereof is to provide a design method of performing an appropriate design to control whether or not detection is possible for the remote sensing, and to provide a design for an evaluation facility for a vehicle driving test device as an example.

### Solution to Problem

The present disclosure relates to a design method for a target object, the design method including an acquisition step of acquiring information about states of reflection and scattering of electromagnetic waves on a target object in a case in which the electromagnetic waves are irradiated onto the target object, an identification step of identifying, based on the information, a portion at which predetermined reflection and scattering occur on the target object, a change step of changing a surface state of the portion at which the predetermined reflection and scattering occur on the target object so that the predetermined reflection and scattering at the portion at which the predetermined reflection and scattering occur on the target object are suppressed, and a verification step of verifying states of the predetermined reflection and scattering of the electromagnetic waves on the target object in a case in which the electromagnetic waves are irradiated onto the target object having the changed surface state.

The present disclosure relates to a design method for a vehicle driving test device including a traveling path on which a test target vehicle moves, a condition reproduction mechanism that reproduces a test condition of the test target vehicle, and a building that covers the traveling path and the condition reproduction mechanism, the design method including an acquisition step of acquiring information about states of reflection and scattering of electromagnetic waves in a case in which the electromagnetic waves are irradiated from an inside of the building onto a target object including the traveling path, the condition reproduction mechanism, and an inner surface of the building, an identification step of identifying, based on the information, a portion at which predetermined reflection and scattering occur on the target object, a change step of changing a surface state of the portion at which the predetermined reflection and scattering occur on the target object so that the predetermined reflection and scattering at the portion at which the predetermined reflection and scattering occur on the target object are suppressed, and a verification step of verifying states of the predetermined reflection and scattering of the electromagnetic waves on the target object in a case in which the electromagnetic waves are irradiated onto the target object having the changed surface state.

### Advantageous Effects of Invention

According to the present disclosure, it is possible to provide the design method for the target object and the design method for the vehicle driving test device which are capable of performing an appropriate design.

### Brief Description of Drawings

Fig. 1 is a flowchart showing an example of a design method for a target object according to the present embodiment.
Fig. 2 is a diagram showing an example of a relationship between an electromagnetic wave arrival direction and a detection result in an acquisition step.
Fig. 3 is a diagram showing an example of a vehicle driving test device according to the present embodiment.
Fig. 4 is a diagram showing an example of an inside of a building in the vehicle driving test device.
Fig. 5 is a diagram showing an example in a case in which the acquisition step is performed inside the building.
Fig. 6 is a diagram showing an example of an radiation range of electromagnetic waves irradiated from an electromagnetic wave radiation source.
Fig. 7 is a diagram showing an example of the radiation range of the electromagnetic waves irradiated from the electromagnetic wave radiation source.
Fig. 8 is a diagram schematically showing an example of a case in which the irradiated electromagnetic waves are received in a reception region.
Fig. 9 is a diagram schematically showing an example of a calculation result in a state shown in Fig. 8.
Fig. 10 is a diagram showing an example in a case in which a surface state of a portion at which predetermined reflection and scattering occur on the target object is changed.
Fig. 11 is a diagram schematically showing an example of a calculation result in a state shown in Fig. 10.

### Description of Embodiments

Hereinafter, an embodiment of a design method for a target object and a design method for a vehicle driving test device according to the present disclosure will be described with reference to the drawings. The present invention is not limited to the embodiment. Further, constituent elements in the following embodiment include constituent elements that can be easily replaced by those skilled in the art or constituent elements that are substantially the same.

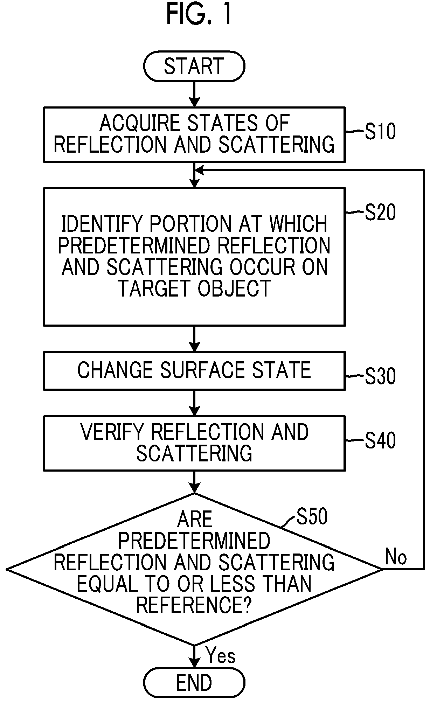

Fig. 1 is a flowchart showing an example of a design method for a target object according to the present embodiment. As shown in Fig. 1, the design method for the target object according to the present embodiment includes an acquisition step S10, an identification step S20, a change step S30, a verification step S40, and a determination step S50. The verification step S40 is a process including at least the same verification as the acquisition step S10 (described later).

In the acquisition step S10, information about states of reflection and scattering of electromagnetic waves on a target object in a case where the electromagnetic waves are irradiated onto the target object is acquired. For example, in a case in which a design for the target object that is difficult to detect by the remote sensing is performed, radio waves are irradiated from all directions to acquire the information about the states of the reflection and scattering of the electromagnetic waves. In addition, in a case in which a surrounding environment in which the target object exists by the remote sensing is optimized, the electromagnetic waves are irradiated from a predetermined location onto the target object to acquire the information about the states of the reflection and scattering of the electromagnetic waves on the target object. Examples of the target object include, but are not limited to, a vehicle driving test device, which will be described later, and the like and other objects or mechanisms may be adopted. In the acquisition step S10, for example, a detection system of a radar, LiDAR, or the like is assumed and the detection is performed by using the radar, LiDAR, or the like, or a simulation is performed by using an electromagnetic field analysis tool, ray tracing, or the like assuming the radar, LiDAR, or the like. In a case in which the electromagnetic waves excessively reflected or scattered on the target object are detected, the magnitude of the reception energy of the reflected or scattered electromagnetic waves, a radar cross section (RCS), or the like is detected. In a case in which the radar cross section is calculated, the radar cross section can be calculated by the selection or combination use according to a monostatic condition based on the electromagnetic waves in which the electromagnetic wave arrival direction and the reflection or scattering direction are the same and a bistatic condition based on the electromagnetic waves in which the electromagnetic wave arrival direction and the reflection and scattering direction are different.

In the identification step S20, based on the information, which is acquired in the acquisition step S10, about the states of the reflection and scattering of the electromagnetic waves on the target object, a portion at which predetermined reflection and scattering occur on the target object is identified. The predetermined reflection and scattering are undesired reflection and scattering of the electromagnetic waves on the target object. Examples of the undesired reflection and scattering of the electromagnetic waves include that the reflection from the design target object is detected by a detection unit of the remote sensing, that the radio waves that are not originally reflected in a direction of the detection unit of the remote sensing are reflected by multiple scattering and are detected by the detection unit, and that a radio wave arrival direction is misidentified due to multiple reflection or the like. For example, in a case in which the design for the purpose of making it difficult to detect by the remote sensing is performed, the reflection and scattering from the design target object are included, and in a case in which the optimization of the surrounding environment in which the target object exists by the remote sensing is performed, the reflection and scattering from a site that should not be a detection target by the remote sensing are included. More specific examples of the undesired reflection and scattering of the electromagnetic waves include the reflection and scattering from a target object (for example, a building 30 or the like) that should not be a detection target by a detection system of a vehicle.

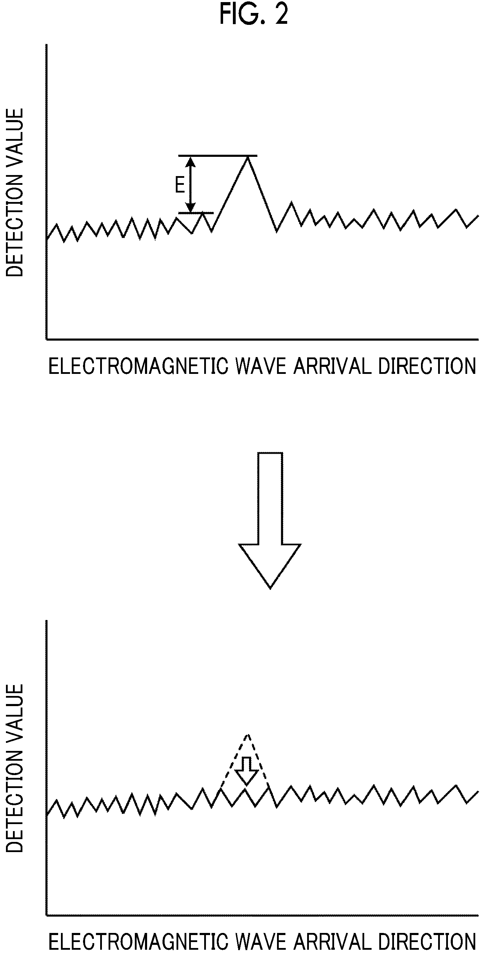

Fig. 2 is a diagram schematically showing an example of a relationship between the electromagnetic wave arrival direction and a detection value in the acquisition step. In Fig. 2, a horizontal axis indicates the electromagnetic wave arrival direction (for example, an angle in a circumferential direction of a horizontal plane). A vertical axis indicates the magnitude of the reception energy or the radar cross section which is the detection value. In the identification step S20, for example, as shown in the upper part of Fig. 2, it can be determined that the predetermined reflection and scattering occur in a case in which there is the electromagnetic wave arrival direction in which a change amount E of the detection value is larger than a threshold value. In this case, the portion at which the predetermined reflection and scattering occur on the target object is identified based on the detection value. In an aspect in which the electromagnetic waves are actually irradiated onto the target object by the detection system such as the radar, LiDAR, or the like to measure the reflection and scattering, in a case in which excessive reflection from the design target object that is difficult to detect by the remote sensing or reflection of the electromagnetic waves from a position at which the target object does not actually exist is detected, an radiation direction in an radiation device, which is associated with a reflection component of the electromagnetic waves can be identified, and a site on the target object existing in the radiation direction which should not be a detection target of the detection system can be set as the portion at which the predetermined reflection and scattering occur on the target object. In addition, in an aspect of grasping the states of the reflection and scattering by a simulation using the electromagnetic field analysis tool or the like, a path and a reflection position of the electromagnetic wave component from an radiation position to a detection position can be discriminated based on the analysis data, and a site on the target object which should not be the detection target of the detection system can be set as the portion at which the predetermined reflection and scattering occur on the target object. The threshold value can be set, for example, based on a minimum reception sensitivity of a sensor or the detection system. In addition, an average value of the detection values in the previous and next time zones, an average value of the detection values in the entire time zone of the electromagnetic waves, or the like can be used. In addition, the identification step S20 may further include a target object distinction recording step and a predetermined reflection and scattering determination step. In the target object distinction recording step, the target object that should not be the detection target by the detection system is recorded for a specific target object (may be recorded corresponding to a 3D model or the like for each specific target object). In the predetermined reflection and scattering determination step, in a case in which the reflection or scattering occurs at least once on the target object that should not be the detection target of the detection system recorded in the target object distinction recording step on a path of a specific electromagnetic wave recorded in the information about the states of the reflection and scattering of the electromagnetic waves in the target object acquired in the acquisition step S10, the electromagnetic wave is determined to be the predetermined reflection or scattering. By further including these steps, it is possible to more quickly identify the portion at which the predetermined reflection and scattering occur on the target object in the identification step.

In the change step S30, a surface state of the portion at which the predetermined reflection and scattering occur on the target object is changed so that the predetermined reflection and scattering at the portion at which the predetermined reflection and scattering occur on the target object are suppressed. In the change step S30, changing the surface state of the portion at which the predetermined reflection and scattering occur on the target object includes at least one of changing a shape of a surface of the portion at which the predetermined reflection and scattering occur on the target object, disposing an electromagnetic wave absorbent material on the surface of the portion at which the predetermined reflection and scattering occur on the target object, and disposing an electromagnetic wave reflecting material on the surface of the portion at which the predetermined reflection and scattering occur on the target object. In a case in which the shape of the surface of the portion at which the predetermined reflection and scattering occur on the target object is changed, the surface state of the portion at which the predetermined reflection and scattering occur on the target object is changed so that the electromagnetic waves are reflected or scattered in a direction different from the electromagnetic wave arrival direction or a direction in which a reception unit of the electromagnetic waves exists. In a case in which the electromagnetic wave absorbent material is disposed on the surface of the portion at which the predetermined reflection and scattering occur on the target object, an electromagnetic wave absorbent material that matches an electromagnetic wave radiation condition is applied so that the energies of the electromagnetic waves toward the electromagnetic wave arrival direction or the direction in which the reception unit of the electromagnetic waves exists can be suppressed. In a case in which the electromagnetic wave reflecting material is disposed on the surface of the portion at which the predetermined reflection and scattering occur on the target object, a shape that suppresses the intrusion of the radio waves into the target object and suppresses the energies of the electromagnetic waves toward the electromagnetic wave arrival direction or the direction in which the reception unit of the electromagnetic waves exists is adopted. The electromagnetic wave absorbing paint may be applied as the disposition of the electromagnetic wave absorbent material.

In the verification step S40, it is verified whether or not the predetermined reflection and scattering at the portion at which the predetermined reflection and scattering occur on the target object are suppressed to be equal to or less than a reference, for the target object of which the surface state of the portion at which the predetermined reflection and scattering occur on the target object is changed. In the verification step S40, the information about the states of the reflection and scattering of the electromagnetic waves is acquired by at least the same method as in the acquisition step S10 described above.

The determination step S50 determines whether or not the predetermined reflection and scattering in the target object are verified to be equal to or less than the reference in the verification step S40. The reference of the predetermined reflection and scattering can be set in advance according to, for example, a configuration of the target object and a type of the electromagnetic waves irradiated onto the target object. In addition, the reference of the predetermined reflection and scattering may be set as an intensity, a range, a duration, etc. of the electromagnetic waves based on a minimum reception sensitivity of a sensor used in the remote sensing or a detection limit of the detection system that detects the target object by the output of the sensor. In the determination step S50, in a case in which it is determined that the predetermined reflection and scattering are equal to or less than the reference (Yes in the determination step S50), the design ends. On the other hand, in a case in which it is not determined that the predetermined reflection and scattering are equal to or less than the reference (No in the determination step S50), the identification step S20, the change step S30, and the verification step S40 are performed again by using the verification result in the verification step S40.

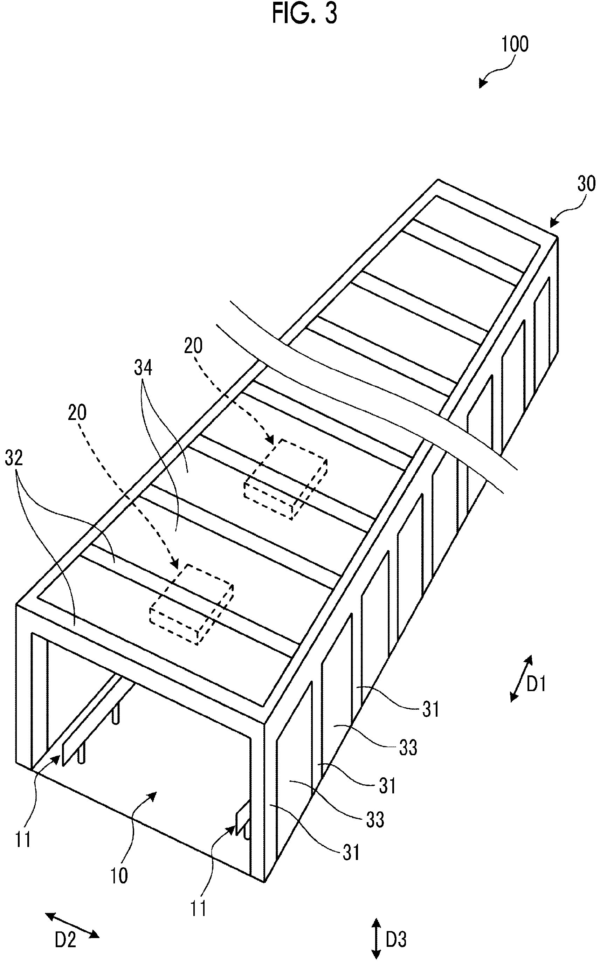

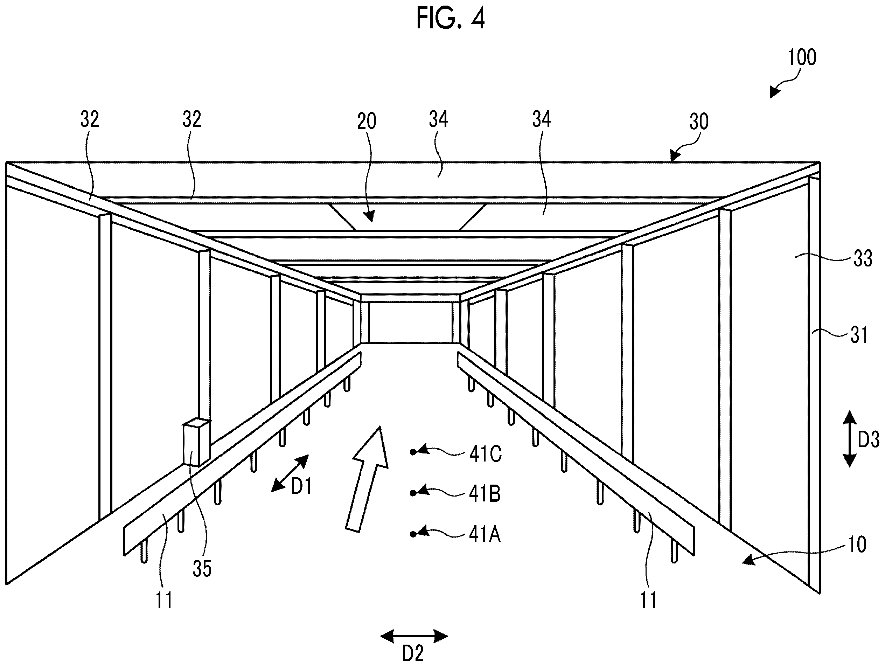

Next, an example in a case in which the vehicle driving test device is designed as the target object will be described. Fig. 3 is a diagram showing an example of a vehicle driving test device 100 according to the present embodiment. Fig. 4 is a diagram showing an example of an inside of the building 30 in the vehicle driving test device 100. The vehicle driving test device 100 shown in Figs. 3 and 4 reproduces a traveling state of the test target vehicle indoors, and performs a test of the test target vehicle. The vehicle driving test device 100 can reproduce a traveling condition, an environmental condition, a weather condition, or the like indoors. The vehicle driving test device 100 reproduces the surrounding environment and a driving state of the test target vehicle, and acquires vehicle operation information of the test target vehicle, thereby performing the test.

As shown in Fig. 3, the vehicle driving test device 100 includes a traveling path 10, a condition reproduction mechanism 20, and the building 30. The traveling path 10 is a region in which the test target vehicle can travel. The traveling path 10 is formed in a state of being paved with asphalt, similarly to, for example, a road or the like. The traveling path 10 is disposed to extend in a linear direction. Hereinafter, a direction parallel to the horizontal plane and extending the traveling path 10 will be referred to as a traveling direction D1. Further, a direction parallel to the horizontal plane and orthogonal to the traveling direction D1 will be referred to as a width direction D2, and a direction orthogonal to the traveling direction D1 and the width direction D2 will be referred to as an up-down direction D3. Guardrails 11 are disposed on both ends of the traveling path 10 in the width direction D2. The guardrails 11 are disposed along the traveling direction D1. In addition, although the traveling path 10 extending in the linear direction is described, the traveling path may include a curve or an intersection. Further, in addition to the traveling path extending in the horizontal direction, a traveling path including a slope or the like may be adopted.

The condition reproduction mechanism 20 performs reproduction so that a test condition around the test target vehicle, such as an environment inside the building 30 or the like, is a predetermined condition. Examples of the condition reproduction mechanism 20 include a facility that reproduces the weather condition around the test target vehicle, such as a precipitation facility, a snowfall facility, a sunshine facility, and a temperature/humidity/pressure regulation facility, a facility that reproduces the traveling condition of the test target vehicle, such as a traffic light, or the like.

The building 30 is a structure in which the traveling path 10 and the condition reproduction mechanism 20 are disposed inside. The building 30 covers the traveling path 10 and the condition reproduction mechanism 20. In the building 30, the surrounding environment of the test target vehicle, which travels for test on the traveling path 10, is an indoor environment. In the building 30, it is preferable that a space on the traveling path 10 is wider than a detection range of the sensor of the test target vehicle.

The building 30 has a pillar portion 31, a beam portion 32, a wall portion 33, and a ceiling portion 34. The pillar portions 31 are disposed, for example, on both sides of the traveling path 10 in the width direction D2. A plurality of pillar portions 31 are disposed in a state of being arranged in the traveling direction D1. The beam portion 32 is disposed above the pillar portion 31. The pillar portion 31 and the beam portion 32 are formed by using, for example, an H material or the like. The wall portions 33 are disposed along the pillar portions 31 on both sides of the traveling path 10 in the width direction D2. The wall portions 33 are disposed on both sides of the traveling path 10 in the traveling direction D1. In Fig. 3, the illustration of the wall portion 33 on the front side in the drawing is omitted. The ceiling portion 34 is disposed along the beam portion 32. In addition, as the building ancillary facility, a support mechanism that suspends the condition reproduction mechanism (rainfall device, fog generation device, snowfall device, solar simulation device, or the like), a lighting, or the like, a pipe, a door or a shutter for taking in and out a measuring device, or the like, and a ventilation facility such as a window, a ventilation fan, or the like may be disposed in the building 30.

As shown in Fig. 4, inside the building 30, the pillar portion 31 is disposed in a state of protruding inward with respect to the wall portion 33. In addition, inside the building 30, the beam portion 32 is disposed in a state of protruding inward with respect to the ceiling portion 34. In addition, as shown in Fig. 4 or the like, a structure 35 such as a fire extinguishing plug, a lighting device, or the like is disposed inside the building 30.

In the vehicle driving test device 100, for example, a test target vehicle equipped with a remote sensing system such as the radar, LiDAR, or the like can be made to travel on the traveling path 10 to perform a test in which the surrounding environment is remotely sensed. In the present embodiment, in a state in which the target object does not exist on the traveling path 10, the guardrails 11 are disposed around the traveling path 10 to perform the test whether or not the test target vehicle can appropriately detect the guardrails 11. The guardrails 11 are not always required. Further, as the detection target to be disposed around the traveling path 10, a detection target different from the guardrail, such as the traffic light or the like, may be disposed. In this case, in addition to the guardrail 11 or the detection target object, the pillar portion 31, the beam portion 32, the wall portion 33, the ceiling portion 34, the building ancillary facility, the structure 35, etc. of the building 30 are disposed around the traveling path 10. In a case in which the test is performed, it is assumed that the electromagnetic waves irradiated from the test target vehicle are on the inner surface of the building 30 including the pillar portion 31, the beam portion 32, the wall portion 33, the ceiling portion 34, the building ancillary facility, and the structure 35, subjected to multiple reflection and scattering or direct reflection and scattering, and detected by the test target vehicle. Among the electromagnetic waves reflected on the inner surface of the building 30, the electromagnetic waves reflected including the constituent portion peculiar to a test facility, such as the pillar portion 31, the beam portion 32, the wall portion 33, the ceiling portion 34, the building ancillary facility, the structure 35, and the like may cause false detection peculiar to the test facility, and thus countermeasures are required.

Therefore, in a case in which the vehicle driving test device 100 configured as described above is designed, for example, a three-dimensional model is created based on the above-described configuration of the vehicle driving test device 100, and each of the steps from step S10 to step S40 described above is performed as a simulation on the three-dimensional model, thereby performing the design for the vehicle driving test device 100 capable of reducing the influence of the false detection. Hereinafter, a case in which the three-dimensional model is created and each of the steps is performed by a simulation will be described.

The three-dimensional model can be created, for example, based on a design drawing of the vehicle driving test device 100 or the like. After the three-dimensional model is created, in the three-dimensional model of the vehicle driving test device 100, the electromagnetic waves are irradiated from the inside of the building 30 onto the target object including the traveling path 10, the condition reproduction mechanism 20 and the inner surface of the building 30 from a position imagining the installation of the radar or LiDAR on the test target vehicle, and the states of the reflection and scattering of the electromagnetic waves on the target object are detected (acquisition step S10) . For the radiation with the electromagnetic waves, the radiation with the electromagnetic waves may be simulated on a simulation.

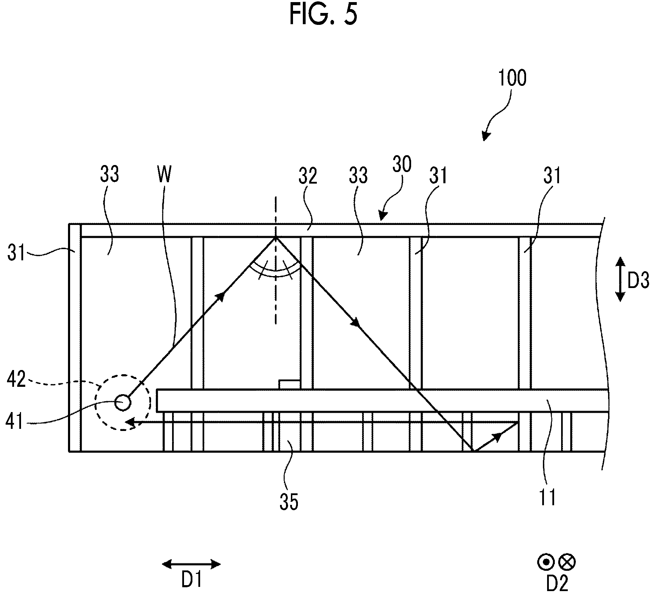

Fig. 5 is a diagram showing an example in a case in which the acquisition step is performed inside the building 30. As shown in Fig. 5, in a case in which the acquisition step S10 is detected, it is assumed that electromagnetic waves W are irradiated from a predetermined position inside the building 30 in the three-dimensional model of the vehicle driving test device 100.

In the present embodiment, for example, an electromagnetic wave radiation source 41 and a reception region 42 are set inside the building 30. The electromagnetic wave radiation source 41 is, for example, an antenna and irradiates the electromagnetic waves W such as millimeter waves or the like. In the present embodiment, the electromagnetic waves W irradiated from the electromagnetic wave radiation source 41 are assumed, and the path of the electromagnetic waves W is calculated based on, for example, the idea that the reflection occurs with an angle based on the Snell's law in a case in which the electromagnetic waves W hit the target object such as a road surface of the traveling path 10, the guardrail 11, or the inner surface of the building 30, such as the pillar portion 31, the beam portion 32, or the like.

The reception region 42 is a region that receives the electromagnetic waves W irradiated from the electromagnetic wave radiation source 41 and reflected or scattered. The reception region 42 is set in a space around the electromagnetic wave radiation source 41, for example, within a predetermined distance from the electromagnetic wave radiation source 41. Therefore, in the present embodiment, among the electromagnetic waves W irradiated from the electromagnetic wave radiation source 41, a component that is reflected on the inner surface of the building 30 and reaches the reception region 42 is detected.

In the present embodiment, it can be assumed that the electromagnetic wave radiation source 41 is disposed at a plurality of radiation positions along the traveling direction D1 of the traveling path 10, simulating that the electromagnetic wave radiation source 41 is mounted on the test target vehicle that moves on the traveling path 10, to irradiate the electromagnetic waves. The continuous motion of the test target vehicle can be represented by measurement results at a plurality of points (point group) in which a mutual distance is set according to the speed of the test target vehicle. In the example shown in Fig. 4, the electromagnetic wave radiation sources 41 are set to be disposed at radiation positions 41A, 41B, and 41C at three locations along the traveling direction D1. Inside the building 30, the state in front of the test target vehicle differs depending on the position on the traveling direction D1. Therefore, by irradiating the electromagnetic waves W from the radiation positions 41A, 41B, and 41C at three locations along the traveling direction D1, the detection result corresponding to the position on the traveling direction D1 can be obtained. The radiation position at which the electromagnetic wave radiation source 41 is disposed is not limited to three locations, and may be two locations or four or more locations.

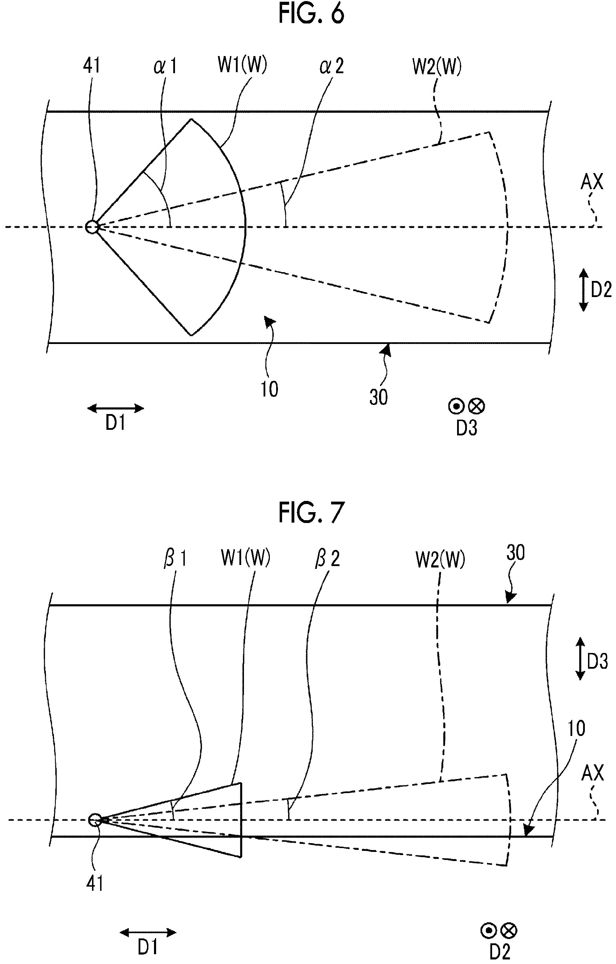

Figs. 6 and 7 are diagrams showing an example of an radiation range of the electromagnetic waves W irradiated from the electromagnetic wave radiation source 41. Fig. 6 is a view seen from above in the up-down direction D3, and Fig. 7 is a view seen from one side in the width direction D2. As shown in Figs. 6 and 7, the electromagnetic wave radiation source 41 irradiates the electromagnetic waves at near field condition W1 and the electromagnetic waves at far field condition W2. The electromagnetic waves at near field condition W1 and the electromagnetic waves at far field condition W2 model a coverage area of the electromagnetic waves irradiated from the remote sensing system such as the radar, LiDAR, or the like mounted on the test target vehicle.

The electromagnetic waves at near field condition W1 are irradiated in a range within an angle αl in the width direction D2 with respect to a reference axis AX parallel to the traveling direction D1 as shown in Fig. 6, and within an angle β1 in the up-down direction D3 with respect to the reference axis AX as shown in Fig. 7. The angle α1 can be set to, for example, about 60° (about 120° in total on the left and right sides). The angle β1 can be set to, for example, about 10° (about 20° in total on the up and down sides). The angles α1 and β1 are not limited to the values described above.

The electromagnetic waves at far field condition W2 are irradiated in a range within an angle α2 in the width direction D2 with respect to a reference axis AX parallel to the traveling direction D1 as shown in Fig. 6, and within an angle β2 in the up-down direction D3 with respect to the reference axis AX as shown in Fig. 7. The angle α2 can be set to, for example, about 9° (about 18° in total on the left and right sides). The angle β2 can be set to, for example, about 7° (about 14° in total on the up and down sides). The angles α2 and β2 are not limited to the values described above.

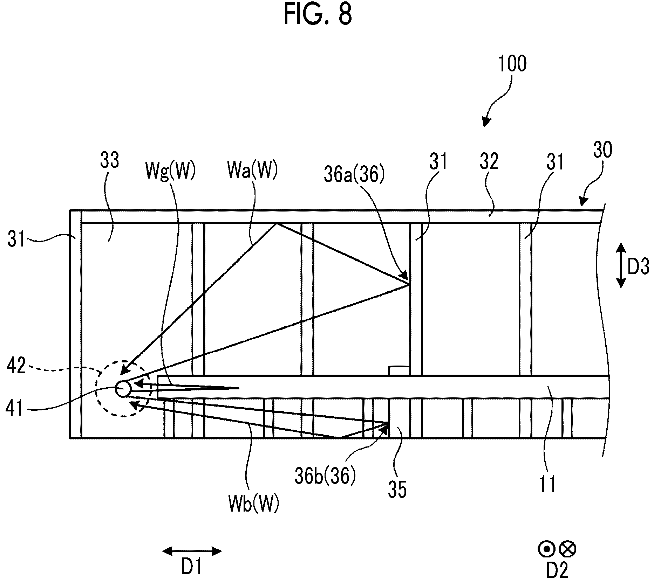

Fig. 8 is a diagram schematically showing an example of a case in which the irradiated electromagnetic waves W are received in the reception region 42. As shown in Fig. 8, the electromagnetic waves W irradiated from the electromagnetic wave radiation source 41 include a component Wg reflected on the guardrail 11 and received by the reception region 42, a component Wa reflected on the inner surface of the building 30, such as the pillar portion 31 or the like, and received by the reception region 42, a component Wb reflected on the structure 35 disposed in the building 30 and received by the reception region 42, or the like. In the identification step S20, coordinates of the position at which the reflection or scattering finally occurs are calculated based on a reception result in the reception region 42.

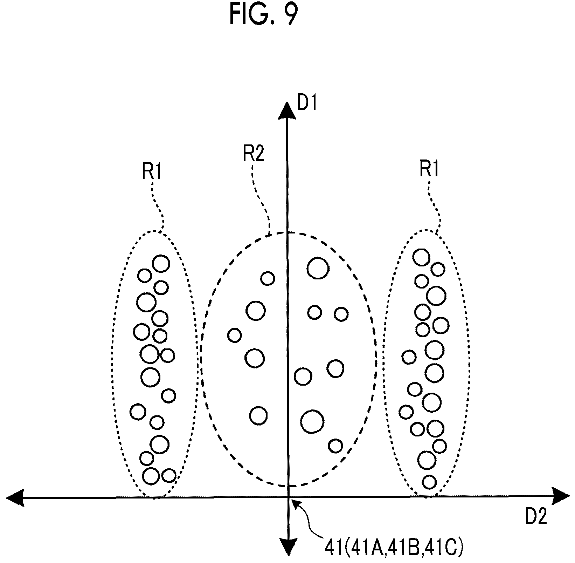

Fig. 9 is a diagram schematically showing an example of a calculation result in the state shown in Fig. 8. Fig. 9 schematically shows coordinates and a reception level at which the reflection of the electromagnetic waves equal to or more than the threshold value is received. A horizontal axis of Fig. 9 is the coordinates in the width direction D2, and a vertical axis is the coordinates in the traveling direction D1. An intersection of the horizontal axis and the vertical axis indicates coordinates of a position at which the electromagnetic wave radiation source 41 is disposed. A position of a circle shown in Fig. 9 indicates coordinates of a position calculated for one electromagnetic wave irradiated from the electromagnetic wave radiation source 41. A size of the circle shown in Fig. 9 indicates the magnitude of the reception energy of the electromagnetic wave received in the reception region 42. In Fig. 9, among the electromagnetic waves W that reaches the reception region 42, the electromagnetic wave having the energy equal to or more than the threshold value is shown as the calculation result. The threshold value can be set in advance.

As shown in Fig. 9, the calculation result in the state of Fig. 8 includes a calculation result R1 of the position corresponding to the guardrail 11 and a calculation result R2 of the position detected on the traveling path 10 in a state in which the target object does not exist. From these calculation results, in a case in which the test target vehicle performs the test for detecting the guardrail 11, it is detected that a plurality of target objects exist on the traveling path 10 in addition to the target object corresponding to the guardrail 11. In the present embodiment, the test is performed in a state in which the target object does not exist on the traveling path 10. Therefore, it can be determined that the target object detected to be exist on the traveling path 10 is a detection result caused by the undesired reflection and scattering. Therefore, based on the detection result of Fig. 9, the calculation result R2 based on such the false detection is used to identify the portion at which the predetermined reflection and scattering occur on the target object (identification step S20). In the identification step S20, a reflection path of the electromagnetic waves corresponding to the calculation result R2 shown in Fig. 9 is calculated, a position of the inner surface of the building 30 at which the electromagnetic waves are reflected and scattered is obtained, and the position of the inner surface of the building 30 is identified as the portion at which the predetermined reflection and scattering occur on the target object. The reflection path of the electromagnetic waves can be calculated based on the condition (radiation direction of the electromagnetic waves or the like) used in step S10. In the example shown in Fig. 8, a position on the pillar portion 31 at which the component Wa is reflected can be identified as a portion 36a at which predetermined reflection and scattering occur on the target object, and a position on the structure 35 at which the component Wb is reflected can be identified as a portion 36b at which predetermined reflection and scattering occur on the target object.

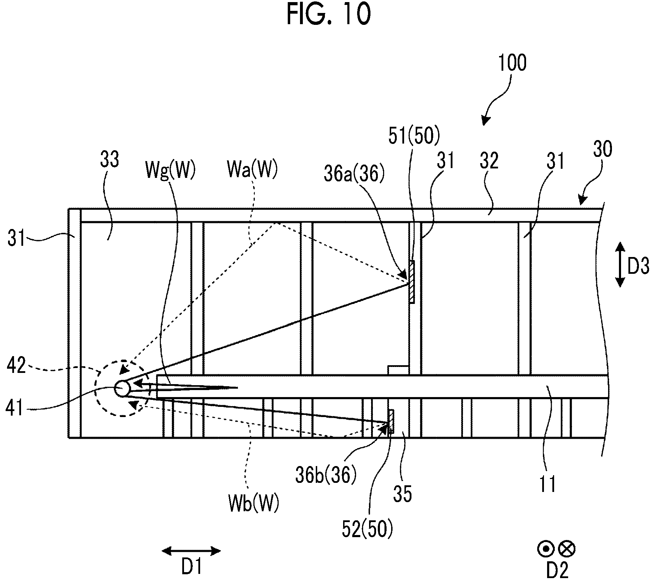

After the portions 36a and 36b at which the predetermined reflection and scattering occur on the target object are identified, the surface states of the portions 36a and 36b at which the predetermined reflection and scattering occur on the target object are changed so that the reflection and scattering at the portions 36a and 36b at which the predetermined reflection and scattering occur on the target object on the inner surface of the building 30 are suppressed (change step S30). In the change step S30, the surface states of the portions 36a and 36b at which the predetermined reflection and scattering occur on the target object can be changed, for example, by disposing an electromagnetic wave absorbent material 50 (refer to Fig. 10 or the like) that absorbs the millimeter waves used as the electromagnetic waves in the present embodiment. As the electromagnetic wave absorbent material 50, a material having a higher millimeter wave absorptance than a material constituting the inner surface of the building 30 (for example, iron, aluminum, or the like) or a material constituting the traveling path 10 (asphalt or the like) can be used. As the electromagnetic wave absorbent material 50, for example, a material having resistance to changes in a climate condition (rain, snow, fog, or the like) caused by the condition change mechanism 20 is used. In the present embodiment, for example, in the three-dimensional model of the vehicle driving test device 100, the reflectance of the electromagnetic waves in the region including the portions 36a and 36b at which the predetermined reflection and scattering occur on the target object is changed to a value in consideration of the absorptance of the electromagnetic wave absorbent material.

Fig. 10 is a diagram showing an example in a case in which the surface states of the portions 36a and 36b at which the predetermined reflection and scattering occur on the target object are changed. As shown in Fig. 10, an electromagnetic wave absorbent material 51 that reduces a reflectance of the component Wa as compared to the pillar portion 31 can be disposed at the portion 36a at which the predetermined reflection and scattering occur on the target object. In addition, an electromagnetic wave absorbent material 52 that reduces a reflectance of the component Wb as compared to the structure 35 can be disposed at the portion 36b at which the predetermined reflection and scattering occur on the target object. The electromagnetic wave absorbent materials 51 and 52 may be set to have the same absorptance of the electromagnetic waves W, or may be set to have different absorptances. The electromagnetic wave absorbent material 50 (51, 52) can be locally disposed on the inner surface of the building 30. Therefore, on the inner surface of the building 30, a region in which the electromagnetic wave absorbent material 50 is disposed and a region in which the electromagnetic wave absorbent material 50 is not disposed are mixed. In this way, by identifying the portion 36 at which the predetermined reflection and scattering occur on the target object and locally disposing the electromagnetic wave absorbent material 50, it is possible to reduce the man-hour and the cost related to manufacturing or maintenance than in a case in which the electromagnetic wave absorbent material 50 is disposed on the entire inner surface of the building 30.

After the surface state of the portion 36a at which the predetermined reflection and scattering occur on the target object is changed, it is verified whether or not the reflection and scattering at the portions 36a and 36b at which the predetermined reflection and scattering occur on the target object are suppressed (verification step S40) . In the verification step S40, the states of the reflection and scattering of the electromagnetic waves are detected in the three-dimensional model of the vehicle driving test device 100 in a state in which the electromagnetic wave absorbent materials 51 and 52 are disposed, by the same method as in the acquisition step S10 described above. As shown in Fig. 10, by disposing the electromagnetic wave absorbent materials 51 and 52, the energies of the components Wa and Wb that reach the portions 36a and 36b at which the predetermined reflection and scattering occur on the target object are absorbed by the electromagnetic wave absorbent materials 51 and 52, and the energies of the reflected waves are reduced. Therefore, it is possible to suppress the reaching of the components Wa and Wb to the reception region 42, or it is possible to reduce the energies of the components Wa and Wb that reach the reception region 42 to be less than, for example, the threshold value described above.

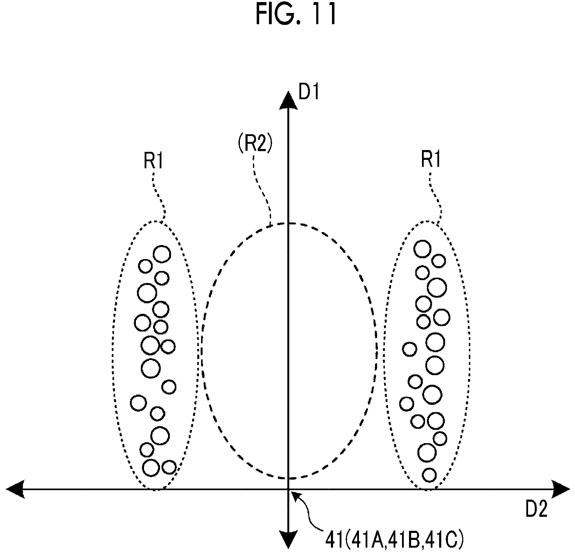

Fig. 11 is a diagram schematically showing an example of a calculation result in the state shown in Fig. 10. Fig. 11 schematically shows coordinates and a reception level at which the reflection of the electromagnetic waves equal to or more than the threshold value is received. A horizontal axis of Fig. 11 is the coordinates in the width direction D2, and a vertical axis is the coordinates in the traveling direction D1. An intersection of the horizontal axis and the vertical axis indicates coordinates of a position at which the electromagnetic wave radiation source 41 is disposed. A position of a circle shown in Fig. 11 indicates coordinates of a position calculated for one electromagnetic wave irradiated from the electromagnetic wave radiation source 41. A size of the circle shown in Fig. 11 indicates the magnitude of the reception energy of the electromagnetic wave received in the reception region 42.

As shown in Fig. 11, the calculation result in the state of Fig. 10 includes the calculation result R1 of the position corresponding to the guardrail 11, but does not include the calculation result of the position corresponding to the inner surface of the building 30. From these calculation results, the detection result is obtained, which indicates that, in a case in which the test target vehicle performs the test for detecting the guardrail 11, the target object corresponding to the guardrail 11 is detected, but no target object other than the guardrail 11 is detected on the traveling path 10. In this case, it is possible to obtain the verification result indicating that the reflection and scattering at the portions 36a and 36b at which the predetermined reflection and scattering occur on the target object are suppressed to be equal to or less than the reference. In addition, in a case in which the detection result is obtained, which indicates that the target object is detected on the traveling path 10 in addition to the guardrail 11, even in a case in which the electromagnetic wave absorbent materials 51 and 52 are disposed at the portions 36a and 36b at which the predetermined reflection and scattering occur on the target object, it is possible to obtain the verification result indicating that the reflection and scattering at the portions 36a and 36b at which the predetermined reflection and scattering occur on the target object are not suppressed to be equal to or less than the reference.

After the verification is performed, it is determined whether or not the predetermined reflection and scattering at the portions 36a and 36b at which the predetermined reflection and scattering occur on the target object are verified to be equal to or less than the reference (determination step S50). In a case in which it is determined that the predetermined reflection and scattering are equal to or less than the reference (Yes in the determination step S50) in the verification result, the design ends. On the other hand, in a case in which it is not determined that the predetermined reflection and scattering are equal to or less than the reference (No in determination step S50), the steps in and after step S20 described above are performed again. As shown in Fig. 4, in a case in which the continuous motion of the test target is represented by the measurement results at the plurality of points, the change step S30 is performed based on the measurement result at each point, and the verification step S40 and the determination step S50 are performed on all the measurement results at the plurality of measured points.

As described above, the design method for the target object according to the present embodiment includes the acquisition step S10 of acquiring the information about the states of the reflection and scattering of the electromagnetic waves on the target object in a case in which the electromagnetic waves are irradiated onto the target object, the identification step S20 of identifying, based on the information, the portion at which the predetermined reflection and scattering occur on the target object, the change step S30 of changing the surface state of the portion at which the predetermined reflection and scattering occur on the target object so that the predetermined reflection and scattering at the portion at which the predetermined reflection and scattering occur on the target object are suppressed, and the verification step S40 of verifying the states of the predetermined reflection and scattering of the electromagnetic waves on the target object in a case in which the electromagnetic waves are irradiated onto the target object having the changed surface state.

Therefore, in a case in which the electromagnetic waves are irradiated onto the target object, the predetermined reflection and scattering in the target object can be suppressed, so that desired measurement can be performed and an appropriate design can be performed.

In the design method for the target object according to the present embodiment, in the change step S30, changing the surface state of the portion at which the predetermined reflection and scattering occur on the target object includes at least one of changing the shape of the surface of the portion at which the predetermined reflection and scattering occur on the target object, disposing the electromagnetic wave absorbent material on the surface of the portion at which the predetermined reflection and scattering occur on the target object, and disposing the electromagnetic wave reflecting material on the surface of the portion at which the predetermined reflection and scattering occur on the target object. Therefore, the predetermined reflection and scattering at the portion at which the predetermined reflection and scattering occur on the target object can be reliably suppressed.

The design method for the target object according to the present embodiment further includes the determination step S50 of determining whether or not the predetermined reflection and scattering on the target object are verified to be equal to or less than the reference in the verification step S40, and performing the identification step S20, the change step S30, and the verification step S40 again by using the verification result in the verification step S40 in a case in which the determination is not made that the predetermined reflection and scattering on the target object are equal to or less than the reference. Therefore, the predetermined reflection and scattering at the portion at which the predetermined reflection and scattering occur on the target object can be reliably suppressed.

The design method for the vehicle driving test device 100 according to the present embodiment is the design method for the vehicle driving test device 100 including the traveling path 10 on which the test target vehicle moves, the condition reproduction mechanism 20 that reproduces the test condition of the test target vehicle, and the building 30 that covers the traveling path 10 and the condition reproduction mechanism 20, the design method including the acquisition step S10 of acquiring the information about the states of the reflection and scattering of the electromagnetic waves W in a case in which the electromagnetic waves W are irradiated from the inside of the building 30 onto the target object including the traveling path 10, the condition reproduction mechanism 20, and the inner surface of the building 30, the identification step S20 of identifying, based on the information, the portion 36 at which the predetermined reflection and scattering occur on the target object, the change step S30 of changing the surface state of the portion 36 at which the predetermined reflection and scattering occur on the target object so that the predetermined reflection and scattering at the portion 36 at which the predetermined reflection and scattering occur on the target object are suppressed, and the verification step S40 of verifying the states of the predetermined reflection and scattering of the electromagnetic waves on the target object in a case in which the electromagnetic waves are irradiated onto the target object having the changed surface state.

Therefore, in a case in which the electromagnetic waves W are irradiated onto the target object including the traveling path 10, the condition reproduction mechanism 20, and the inner surface of the building 30, the predetermined reflection and scattering in the target object can be suppressed, so that desired measurement can be performed and an appropriate design can be performed.

In the design method for the vehicle driving test device 100 according to the present embodiment, the change step S30 includes at least one of changing the shape of the surface of the portion 36 at which the predetermined reflection and scattering occur on the target object, disposing the electromagnetic wave absorbent material 50 on the surface of the portion at which the predetermined reflection and scattering occur on the target object, and disposing the electromagnetic wave reflecting material on the surface of the portion 36 at which the predetermined reflection and scattering occur on the target object. Therefore, the predetermined reflection and scattering at the portion 36 at which the predetermined reflection and scattering occur on the target object can be reliably suppressed.

The design method for the vehicle driving test device 100 according to the present embodiment further includes the determination step S50 of determining whether or not the predetermined reflection and scattering on the target object are verified to be equal to or less than the reference in the verification step S40, and performing the identification step S20, the change step S30, and the verification step S40 again by using the verification result in the verification step S40 in a case in which the determination is not made that the predetermined reflection and scattering on the target object are equal to or less than the reference. Therefore, the predetermined reflection and scattering at the portion 36 at which the predetermined reflection and scattering occur on the target object can be reliably suppressed.

In the design method for the vehicle driving test device 100 according to the present embodiment, in the acquisition step S10, the information about the states of the reflection and scattering of the electromagnetic waves in a case in which the electromagnetic waves W are irradiated from the plurality of positions 41A, 41B, and 41C along the traveling path 10 of the test target vehicle is acquired (acquired by simulating the radiation in the simulation). Inside the building 30, the state in front of the test target vehicle differs depending on the position on the traveling direction D1. Therefore, by irradiating the electromagnetic waves W from the radiation positions 41A, 41B, and 41C at three locations along the traveling direction D1 of the traveling path 10, the detection result corresponding to the position on the traveling direction D1 can be obtained.

In the design method for the vehicle driving test device 100 according to the present embodiment, the predetermined reflection and scattering are reflection and scattering on the inner surface of the building 30. Therefore, the influence of the reflection and scattering on the inner surface of the building 30 can be suppressed.

In the design method for the vehicle driving test device 100 according to the present embodiment, the inner surface of the building 30 has the pillar portion 31, the beam portion 32, the wall portion 33, and the ceiling portion 34 constituting the building 30, the building ancillary facility, and at least one surface of the structure 35 installed in the building 30. Therefore, the influence of the reflection and scattering corresponding to the specific structure constituting the building 30 can be suppressed.

The technical scope of the present invention is not limited to the embodiment described above, and can be appropriately changed without departing from the gist of the present invention.

### Reference Signs List

- 10: Traveling path
- 11: Guardrail
- 20: Condition reproduction mechanism
- 30: Building
- 31: Pillar portion
- 32: Beam portion
- 33: Wall portion
- 34: Ceiling portion
- 35: Structure
- 36, 36a, 36b: Portion at which predetermined reflection and scattering occur on target object
- 41: Electromagnetic wave radiation source
- 41A, 41B, 41C: Radiation position
- 42: Reception region
- 50, 51, 52: Electromagnetic wave absorbent material
- 100: Vehicle driving test device
- AX: Reference axis
- D1: Traveling direction
- D2: Width direction
- D3: Up-down direction
- W: Electromagnetic wave
- W1: Electromagnetic waves at near field condition
- W2: Electromagnetic waves at far field condition
- Wa, Wb, Wg: Component
- α1, β1, α2, β2: Angle

## Claims

1. A design method for a target object, the design method comprising:
an acquisition step of acquiring information about states of reflection and scattering of electromagnetic waves on a target object in a case in which the electromagnetic waves are irradiated onto the target object;
an identification step of identifying, based on the information, a portion at which predetermined reflection and scattering occur on the target object;
a change step of changing a surface state of the portion at which the predetermined reflection and scattering occur on the target object so that the predetermined reflection and scattering at the portion at which the predetermined reflection and scattering occur on the target object are suppressed; and
a verification step of verifying states of the predetermined reflection and scattering of the electromagnetic waves on the target object in a case in which the electromagnetic waves are irradiated onto the target object having the changed surface state.

2. The design method for a target object according to Claim 1,
wherein, in the change step, changing the surface state of the portion at which the predetermined reflection and scattering occur on the target object includes at least one of changing a shape of a surface of the portion at which the predetermined reflection and scattering occur on the target object, disposing an electromagnetic wave absorbent material on the surface of the portion at which the predetermined reflection and scattering occur on the target object, and disposing an electromagnetic wave reflecting material on the surface of the portion at which the predetermined reflection and scattering occur on the target object.

3. The design method for a target object according to Claim 1 or 2, further comprising:
a determination step of determining whether or not the predetermined reflection and scattering on the target object are verified to be equal to or less than a reference in the verification step, and performing the identification step, the change step, and the verification step again by using a verification result in the verification step in a case in which a determination is not made that the predetermined reflection and scattering on the target object are equal to or less than the reference.

4. A design method for a vehicle driving test device including a traveling path on which a test target vehicle moves, a condition reproduction mechanism that reproduces a test condition of the test target vehicle, and a building that covers the traveling path and the condition reproduction mechanism, the design method comprising:
an acquisition step of acquiring information about states of reflection and scattering of electromagnetic waves in a case in which the electromagnetic waves are irradiated from an inside of the building onto a target object including the traveling path, the condition reproduction mechanism, and an inner surface of the building;
an identification step of identifying, based on the information, a portion at which predetermined reflection and scattering occur on the target object;
a change step of changing a surface state of the portion at which the predetermined reflection and scattering occur on the target object so that the predetermined reflection and scattering at the portion at which the predetermined reflection and scattering occur on the target object are suppressed; and
a verification step of verifying states of the predetermined reflection and scattering of the electromagnetic waves on the target object in a case in which the electromagnetic waves are irradiated onto the target object having the changed surface state.

5. The design method for a vehicle driving test device according to Claim 4,
wherein the change step includes at least one of changing a shape of a surface of the portion at which the predetermined reflection and scattering occur on the target object, disposing an electromagnetic wave absorbent material on the surface of the portion at which the predetermined reflection and scattering occur on the target object, and disposing an electromagnetic wave reflecting material on the surface of the portion at which the predetermined reflection and scattering occur on the target object.

6. The design method for a vehicle driving test device according to Claim 4 or 5, further comprising:
a determination step of determining whether or not the predetermined reflection and scattering on the target object are verified to be equal to or less than a reference in the verification step, and performing the identification step, the change step, and the verification step again by using a verification result in the verification step in a case in which a determination is not made that the predetermined reflection and scattering on the target object are equal to or less than the reference.

7. The design method for a vehicle driving test device according to any one of Claims 4 to 6,
wherein, in the acquisition step, information about states of reflection and scattering of the electromagnetic waves in a case in which the electromagnetic waves are irradiated from a plurality of positions along the traveling path of the test target vehicle is acquired.

8. The design method for a vehicle driving test device according to any one of Claims 4 to 7,
wherein the predetermined reflection and scattering are reflection and scattering on the inner surface of the building.

9. The design method for a vehicle driving test device according to Claim 8,
wherein the inner surface of the building has a pillar portion, a beam portion, a wall portion, and a ceiling portion constituting the building, a building ancillary facility, and at least one surface of a structure installed in the building.
